(19) Europäisches Patentamt
European Patent Office
Office européen des brevets

(11) **EP 1 330 833 B1**

(12) **EUROPÄISCHE PATENTSCHRIFT**

(45) Veröffentlichungstag und Bekanntmachung des Hinweises auf die Patenterteilung:
**18.04.2007 Patentblatt 2007/16**

(51) Int Cl.:
*H01J 49/00* (2006.01)  *H01L 29/76* (2006.01)
*H01J 49/44* (2006.01)

(21) Anmeldenummer: **01974137.0**

(22) Anmeldetag: **08.08.2001**

(86) Internationale Anmeldenummer:
**PCT/EP2001/009158**

(87) Internationale Veröffentlichungsnummer:
**WO 2002/019383 (07.03.2002 Gazette 2002/10)**

(54) **ELEKTRONENSPEKTROMETER**

ELECTRON SPECTROMETER

SPECTROMETRE ELECTRONIQUE

(84) Benannte Vertragsstaaten:
**AT BE CH CY DE DK ES FI FR GB GR IE IT LI LU MC NL PT SE TR**

(30) Priorität: **31.08.2000 DE 10042663**

(43) Veröffentlichungstag der Anmeldung:
**30.07.2003 Patentblatt 2003/31**

(73) Patentinhaber: **NaWoTec GmbH**
**64380 Rossdorf (DE)**

(72) Erfinder:
• **KOOPS, Hans, W., P.**
**64372 Ober-Ramstadt (DE)**
• **KAYA, Alexander**
**64380 Rossdorf (DE)**

(74) Vertreter: **Borchert, Uwe Rudolf et al**
**Puschmann & Borchert**
**Patentanwälte**
**European Patent Attorneys**
**Postfach 10 12 31**
**80086 München (DE)**

(56) Entgegenhaltungen:
**EP-A- 0 626 730**    **EP-A- 0 750 353**
**EP-A- 0 836 232**    **WO-A-00/41245**
**US-A- 5 347 140**    **US-A- 5 350 931**
**US-A- 6 159 620**

• **DUTTA A ET AL: "SINGLE-ELECTRON TUNNELING DEVICES BASES ON SILICON QUANTUM DOTS FABRICATED BY PLASMA PROCESS" , JAPANESE JOURNAL OF APPLIED PHYSICS, PUBLICATION OFFICE JAPANESE JOURNAL OF APPLIED PHYSICS. TOKYO, JP, VOL. 39, NR. NO 1, PART 1, PAGE(S) 264-267 XP002945643 ISSN: 0021-4922 Seite 264 -Seite 267**
• **PATENT ABSTRACTS OF JAPAN vol. 1995, no. 11, 26. Dezember 1995 (1995-12-26) & JP 07 226522 A (HITACHI LTD), 22. August 1995 (1995-08-22)**

EP 1 330 833 B1

**Beschreibung**

Derzeitige Mess- und Herstellungsverfahren für Einzel-Elektronen-Elektronik, Single Electron Tunneling (SET)-Elektronik und ihre Anwendungen (wie beispielsweise der SET-Transistor) beruhen auf Halbleitern (z. B. laterale GaAs/AlGaAs-Heterostrukturen) bzw. metallischen Quantenpunkten, die mit metallischen oder halbleitenden Kontaktierungen für elektrische Meßgeräte zugänglich gemacht werden. [T.H. Oosterkamp, L.P. Kouwenhoven, A.E.A. Koolen, N.C. van der Vaart, and C.J.P.M. Harmans, Phys. Rev. Lett. **78,** 1536 (1997)] Herkömmliche Herstellungsverfahren der Dünnfilmtechnik erreichen Quantenpunkte mit Abmessungen im 20 nm Bereich, welche durch die quantenmechanischen Gesetze nur Energie-Niveaus besitzen, die eine Auftrennung der Elektronenniveaus von einigen 100 $\mu$eV ermöglichen. Aufgrund der geringen Abständen zwischen benachbarten diskreten Energiestufen werden zur Beobachtung und Verwendung der auf der Coulomb-Blockade in diesen Quantenpunktsystemen beobachteten und erzeugten Effekte sehr niedrige Temperaturen (<4 K) benötigt. Dann können die im Metallgitter existierenden Phononen der Energie kT keine Elektronen mehr anregen und somit von Energieniveau zu Energieniveau anheben.

Aufgabe der Erfindung ist es , ein Messverfahren für Einzel-Elektronen-Elektronik bei Raumtemperatur verfügbar zu machen.

Gelöst wird die Aufgabe durch den Hauptanspruch in Verbindung mit den Unteransprüchen.

Eine neuartige Anordnung für die Nutzbarmachung von Einzel-Elektronen-Elektronik Raumtemperatur-Anwendungen (Single-Electron-Tunnelling, SET) durch die Ausnutzung von lokalisierten, 0-dimensionalen Zuständen in ungeordneten nanokristallinen Systemen für ein Elektronenspektrometer wird beschrieben. Das Elektronenspektrometer besteht aus Leiterbahnverbindungen, die aus einem nanokristallinen Verbundwerkstoff, welcher aus Metall-oder Halbleitermaterial-Nanokristallen in einer nichtleitfähigen Matrix besteht, gefertigt werden, und die Einzel-Elektronen-Elektronik Schaltung mit zur Außenwelt führenden Metall-Leitungen verbindet. In den Nanokristallen der Zuleitungen existieren lokalisierte Elektronenwellenpakete, die entsprechend den Bohr'schen Bedingungen für Eigenlösungen im Zentralpotential in den Elektronen-Wellen Moden des Elektronengases der einzelnen Nanopartikel räumlich und energetisch diskrete Werte annehmen und daher stark gequantelte Systeme darstellen (0-dimensionales Elektronengas). Ein Elektron, das sich in diesem System befindet, nimmt diskrete Zustände an und verharrt so lange an seinem Ort, bis er durch äußere Anregung z.B. durch angelegte Spannung, oder Einfluß von Phononen, an den nächsten freien und energetisch günstigen Ort wandert bzw. hüpft ("Hopping"-Leitung). In Abhängigkeit und bei geeigneter Wahl dieser diskreten Energieabstände kann eine Elektronenleitung für vorgegebene Temperaturen unterdrückt bzw. begünstigt werden.

Das beschriebene Elektronenspektrometer bedient sich dieser Prinzipien zur Nutzbarmachung von Quantenpunktsystemen und SET-Anwendungen wie dem SET-Transistor, indem geeignete ungeordnete Materialien den Quantenpunkten zur elektrischen Kontaktierungen der zu untersuchenden Quantenpunkt-Systeme, -Bauelemente oder -Schaltungen vorangeschaltet und nachgeschaltet werden. Aufgrund der Tatsache, daß Elektronen in diesen Materialien selbst bei Raumtemperatur an ihren Stellen "haften", wird der Störeinfluß von zu hohen Temperaturen auf den Quantenpunkt bzw. auf die Coulomb-Blockade unterdrückt.

Im Folgenden wird die Erfindung anhand der Figuren näher erläutert.

Es zeigt

Figur 1   eine schematische Darstellung des Elektronenspektrometers für Einzel-Elektronen-Elektronik,

Figur 2   das Schema der Ausführungsform des Elektronenspektrometers, wie es durch rechnergesteuerte korpuskularstrahlinduzierten Deposition aus einem goldhaltigen Ausgangsmaterial in eine vorbereitete metallische Anschlussstruktur hinein hergestellt werden kann,

Figur 3:   eine stromstabilisierte Strom/Spannungscharakteristik eines nach Fig. 2 experimentell ausgeführten Elektronenspektrometers zur Messung der Coulomb-Oszillation in einem Quantenpunktsystem, und

Figur 4   das Schema der Ausführungsform des Elektronenspektrometers mit Energie- und Spin-Selektions-Bereich zur Voreinstellung und zur Analyse der Wirkung des Bauelementes.

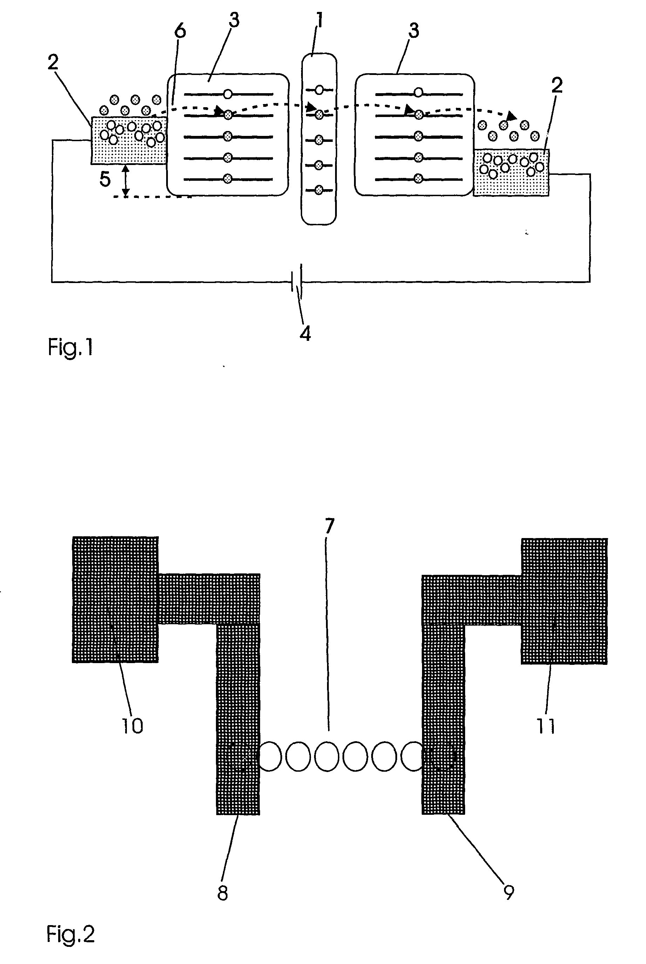

Das Arbeitsprinzip ist in Figur 1 dargestellt: Der Quantenpunkt (1) ist links und rechts von den elektrischen Kontaktierungen (2) räumlich getrennt und von dem 0-dimensionalen Elektronengasmaterial (3) umgeben. Die elektrischen Kontakte sind mit einer Spannungsquelle (4) verbunden, mit deren Hilfe sich das Potential der Kontaktelektronen (5) variieren läßt. Ein Abwandern der Elektronen vom rechten Kontakt (6)in die diskreten Zustände des 0-dimensionalen Elektronengases ist nur möglich, wenn die thermischen Elektronen des Kontaktmaterials über die Spannungsquelle energetisch derart angehoben werden, daß sie mit einem diskreten Niveau des 0-dimensionalen Systems zusammenfallen. Ferner werden Raumtemperaturelektronen blockiert, wenn die Energieniveaus breiter separiert sind als $kT_{Raum.}$ Der Quantenpunkt (1) ist somit von einer "eingefrorenen" Elektronenumgebung umgeben. Ein Transport dieser kalten Elektronen zu dem Quantenpunkt ist nur möglich, wenn eines seiner Niveaus mit einem ebenfalls durch die Spannungsquelle verschiebbaren Niveau des 0-dimensionalen Elektronengases zusammenfällt. Der weitere Transportverlauf reproduziert sich in der rechten 0-dimensionalen Elektronenumgebung, bis die Elektronen mit Erreichen der elektrischen Kontaktierung einen geschlossenen Stromkreis mit diskreter Strom/ Spannungscharakteristik bilden.

Das beschriebene Verfahren wurde mit Hilfe der korpuskularstrahlinduzierten Deposition experimentell realisiert und durch elektrische Messungen bei Raumtemperaturen bestätigt.

Dieses neuartige Verfahren der Materialherstellung zeichnet sich durch den Einsatz organometallischer Verbindungen sowie von Korpuskularstrahlen höchster Leistungsdichte bei höchster lokaler Abgrenzung aus. Auf der Oberfläche eines Substrates adsorbierte Schichten der organometallischen Verbindung werden durch den Beschuß mit Korpuskularstrahlen in nanokristalline Substanzen umgewandelt. Diese nanokristallinen Verbundmaterialien bestehen aus segregierten Edelmetall-Einkristalliten, die in einer nichtleitenden Matrix eingeschlossen sind. Damit bilden diese Materialien ungeordnete Systeme, in denen lokalisierte Energiezustände die tragende Rolle für alle Transportvorgänge (Hopping) sind. Die elektrische Leitfähigkeit ist gegeben durch:

$$\sigma \propto e^{-\left(T_0/T\right)^x}$$

wobei $T_0$ und $x$ Konstanten sind und für dreidimensionale Komposite (Cermets) $x \approx 0.5$ gilt. Das Gesetz wurde an den durch korpuskularstrahlinduzierten Deposition hergestellten Materialien mit organometallischen Ausgangsmaterialien experimentell bestätigt und zeigt für gold- u. platinhaltige Materialien einen Exponenten $x \approx 0.5$ in einem großen Temperaturbereich . Da die Hopping-Aktivierungsenergien bzw. die Abstände besetzbarer benachbarter diskreter Energiezustände in Abhängigkeit der Temperatur zwischen 30 meV und 150 meV liegen, eignen sich diese Materialien mit Vorzug als 0-dimensionale Umgebungen für Raumtemperatur-Quantenpunktsysteme.

Das Verfahren wurde mit dem Prozeß der korpuskularstrahlinduzierten Deposition, einem neuartigen Verfahren der Materialherstellung, das sich durch den Einsatz von organometallischen Verbindungen auszeichnet, experimentell bestätigt und zeigt bei Raumtemperatur an Quantenpunktsystemen Coulomb-Oszillationen mit Spannungsausschlägen um bis zu 50 mV

Figur 2 zeigt schematisch ein Quantenpunktsystem (7), bestehend aus mehreren in Serie geschalteten Quantenpunkten mit Durchmessern von ca. 30 nm, welche mit Hilfe der korpuskularstrahlinduzierten Deposition aus einer z.B. goldhaltigen organometallischen Ausgangssubstanz hergestellt wurden. Dabei sind die Quantenpunkte selbst wiederum aus Nanokristallinem Material mit Kristallitgrößen im nm-Bereich aufgebaut, welche das Elektronengas der Kristallite quantisiert. Die beiden Zuleitungen links (8) und rechts (9) wurden ebenfalls mit dem Depositionsverfahren aus Nanokristalliten in einer nichtleitenden Matrix hergestellt und dienen als 0-dimensionales Elektronengas Energiefilter für die Versorgung der Struktur mit energieselektierten Elektronen. Die elektrischen Kontaktierungen (10) und (11) liefern mit ihrem 3-dimensionalen Elektronengas die erforderlichen Elektronen zur Versorgung der Schaltung nach und tragen die Signale zur Meßelektronik in der Außenwelt.

Die Anordnung des Elektronenspektrometers wurde an einer mit dem Prozeß der korpuskularstrahlinduzierten Deposition hergestellten Struktur experimentell bestätigt. Feinste Strukturen bis herab zu 5 nm Punktdurchmesser mit einer Kantenrauhigkeit von 2 nm werden durch Elektronenstrahlinduzierte Deposition im Rasterelektronenmikroskop oder STM Scanning Tunneling Micsroscope(Raster-Tunnel Mikroskop) hergestellt.

Die beschriebene Anordnung des Elektronenspektrometers wurde unter Rechnersteuerung der Deposition und damit der Materialzusammensetzung erzeugt, und verwendet das mit dem Verfahren hergestellte neuartige nanokristalline Material, welches aus ungeordneten Kristall-Systemen besteht, in dem sich lokalisierte, 0-dimensionale Systeme dadurch ausbilden, daß Elektronenwellen in den Nanokristallen konstruktiv zu örtlich und energetisch lokalisierten Wellenpaketen interferieren. Damit besitzen die Nanokristalle ein Null-dimensionales Elektronengas mit großen Energieniveauabständen. Da diese diskreten Energiestufen in den Nanokristallen bei Kristallitgrößen von 2 bis 4 nm Durchmesser sich um bis zu 150 meV unterscheiden, wird eine Verschmierung oder Störung der Coulomb-Blockade selbst durch Elektronenanregung mit Phononen, die bei Raumtemperatur eine Energie von kT = 25 meV besitzen, unterdrückt. Durch die Tatsache, daß kein ausgedehntes Kristallgitter existiert, in welchem sich Phononen ungestreut ausbreiten könnten, bestehen in dem nanokristallinen Material keine Phononen. Das verringert die Verschmierung der Energie der die Signale tragenden Elektronen weiter.

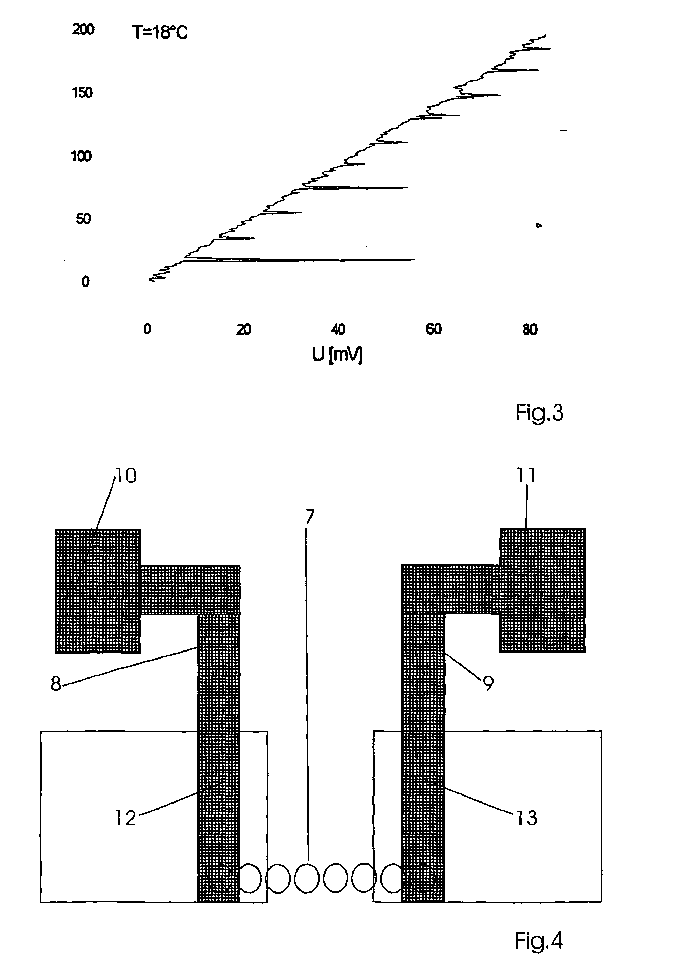

In Figur 3 ist die Strom/Spannungscharakteristik der Anordnung wiedergegeben, welche, die im stromstabilisierten Betrieb bei Raumtemperatur (20 C) an einer der Figur 2 entsprechenden experimentell realisierten Struktur gemessen wurde.

Es zeigen sich bei der Messung bei Raumtemperatur charakteristische diskrete Spannungsausschläge um bis zu 50 mV, wie sie in ähnlicher Weise für Doppel-Quantenpunkte bei tiefen Temperaturen beobachtet werden.

Mit Vorteil wird das Eektronenspektrometer zum aktiven Messgerät zur Untersuchung von Einzel-Elektronen-Bauelementen und -Schaltungen, wenn die nanokristallinen Zu und Ableitungen zu den zu untersuchenden Einzel-Elektronen-Elektronik-Bauelementen und - Schaltungen aus speziell gefertigte Quantenpunkten mit weit getrennten Energieniveaus ausgebildet werden, mit deren Hilfe es möglich ist durch Einsatz von physikalischen Einflüssen wie Druck, Zug, lokaler Temperatur, spektrale Beleuchtung, elektrischer-, magnetischer Feldstärke von außen die Energie und den Spin der zur Untersuchung verwendeten Elektronen beeinflusst und gezielt einzustellen und, die durchgelassenen spektroskopisch selektierten Elektronen in ihrem Elektronenspin selektiert zu definieren und einzustellen und dem Untersuchungsobjekt zuzuführen. Es ist weiterhin vorteilhaft ähnlich aufgebaute speziell gefertigte Quantenpunkte mit weit getrennten Energieniveaus dem Untersuchungsobjekt nachzuschalten, mit deren Hilfe es möglich ist durch Einsatz von physikalischen Einflüssen wie Druck, Zug, lokaler Temperatur, elektrischer-, magnetischer Feldstärke von außen beeinflusst und gezielt eingestellt, die durchgelassenen spektroskopisch selektierten Elektronen in ihrem Elektronenspin selektiert zu analysieren und so Aussagen über die Wirkung des Untersuchungsobjekts messend und analysierend zu erfassen.

Ein Figur 4 ist das Schema der Ausführungsform des Elektronenspektrometers mit Energie-und Spin-Selektions-Bereich zur Voreinstellung (12,13) und zur Analyse der Wirkung des Bauelements (7) wiedergegeben.

Ungeordnete lokalisierte Systeme werden also in einer neuartigen Anordnung als Elektronenspektrometer zur Nutzbarmachung von Einzel-Elektonen-Elektronik-Anwendungen bei Raumtemperatur eingesetzt. Die als Elektronenspektrometer wirkende Anordnung besteht aus einem nanokristallinen Material aus Metall oder Halbleitermaterial, das als Leiterbahnverbindung als Zu- und Abführung zu den Einzel-Elektronen-Elektronik-Bausteinen und Schaltungen, die aus lithographisch hergestellten Quantenpunkten bestehen, eingesetzt wird. Das Elektronensystem des nanokristallinen Materials ist dadurch gekennzeichnet, dass ausschließlich räumlich und energetisch lokalisierte (diskrete) Elektronenzustände mit Energieabständen von mehreren meV in ihm vorhanden sind (0-Dimensionales Elektronengas). Dies zeichnet auch das Energieniveausystem der Quantenpunkte aus. Elektronen, die in herkömmlichen metallischen Kontaktierungen ein 3-dimensionales Elektronengas bilden und durch direkten Kontakt in dieses 0-dimensionale Elektronengas weitergeleitet werden, erfahren eine spektroskopische Ausfilterung derart, dass sie nur noch die diskreten Energiezustände des 0-dimensionalen Elektronengases in der Leiterbahn besetzen können. Sind die Abstände dieser diskreten Energiezustände größer als die Energie der Phononen bei Raumtemperatur d. h. > kT = 25 meV, so blockiert (filtert) das System alle vom Metall der Anschlussleitungen kommenden Elektronen so, dass ein Elektronentransport nur noch durch eine außen anliegende Spannung durch den Leitungsmechanismus des "Hopping" über die diskreten Energiezustände des Materials mit 0-dimensionalem Elektronengas möglich ist. Die nachfolgend aus Quantenpunkten bestehende Einzel-Elektronen-Elektronik wird damit mit energetisch sehr scharf definierten Elektronen versorgt. Sie kann so von Phononen ungestört bei Raumtemperatur betrieben werden.

**Patentansprüche**

1. Elektronenspektrometer für die Versorgung und Vermessung von Einzel-Elektronen-Elektronik-Bauelementen und -Schaltungen beinhaltend Verbindungselemente bestehend aus Hopping-leitfähigen-Leiterbahnen aus nanokristallinem Material, das getrennte Energieniveaus ähnlich eines 0-dimensionalen Elektronengases aufweist, die mit dem zu untersuchenden Einzel-Elektronen-Elektronik-Bauelement oder-Schaltung verbunden sind, und Leitungen aus Metall, die mit den genannten Verbindungselementen und einer Spannungsquelle verbunden sind.

2. Elektronenspektrometer für die Versorgung und Vermessung von Einzel-Elektronen-Elektronik-Bauelementen und -Schaltungen nach Anspruch 1, wobei die Energieaufspaltung der Energieniveaus der Leiterbahnen wenigstens 25 meV beträgt, was der Phononenenergie bei Raumtemperatur entspricht, um Effekte der thermischen Störung auf die Coulomb-Blockade in den Einzel-Elektronen-Elektronik-Bauelementen und Schaltungen bei Raumtemperatur zu unterdrücken.

3. Elektronenspektrometer für die Versorgung und Vermessung von Einzel-Elektronen-Elektronik-Bauelementen und -Schaltungen bei Raumtemperatur nach den Ansprüchen 1 und 2, wobei den zu untersuchenden Einzel-Elektronen-Elektronik-Bauelementen und -Schaltungen mehrere Quantenpunkte vor- und nachgeschaltet sind und die Quantenpunkte bei Raumtemperatur - Energieniveauabstände größer 25 meV aufweisen.

4. Verfahren für die Versorgung und Vermessung von Einzel-Elektronen-Elektronik-Bautelementen und -Schaltungen unter Verwendung eines Elektronenspektrometers, wobei das Elektronenspektrometer Verbindungselemente bestehend aus Hopping-leitfähigen Leiterbahnen aus nanokristallinem Material, das getrennte Energieniveaus ähnlich eines 0-dimensionalen Elektronengases aufweist, die mit dem zu untersuchenden Einzel-Elektronen-Elektronik-Bauelement oder -Schaltung verbunden sind, und Leitungen aus Metall, die mit den genannten Verbindungselementen und einer Spannungsquelle verbunden sind, beinhaltet, wobei die aus den Leitungen aus Metall angebotenen Elektronen durch die in dem Hopping-leitfähigen Leiterbahnen aus nanokristallinem Material vorliegenden diskreten Energieniveaus in ihrer Energie selektiert werden und in spektroskopischer Weise nach Energien gefiltert und der zu untersuchenden Einzel-Elektronen-Elektronik zugeführt werden.

5. Verfahren nach Anspruch 4, wobei den zu untersuchenden Einzel-Elektronen-Elektronik-Bauelementen und -Schaltungen mehrere Quantenpunkte vor- und nachgeschaltet sind, wobei die Quantenpunkte bei Raumtemperatur Energieniveauabstände größer 25 meV aufweisen, dass die Quantenpunkte durch Einsatz von physikalischen Einflüssen wie Druck, Zug, lokaler Temperatur, spektrale Beleuchtung, elektrischer-, magnetischer Feldstärke in ihrer Energieaufspaltung zur Abstimmung der Elektronenenergie an die zu untersuchenden Einzel-Elektronen-Objekte von außen beeinflusst und gezielt eingestellt werden und dass **dadurch** die durchgelassenen spektroskopisch selektierten Elektronen in ihrem Elektronenspin selektiert definiert und eingestellt werden und dem Untersuchungsobjekt zugeführt werden.

6. Verfahren nach Anspruch 5, wobei die durchgelassenen spektroskopisch selektierten Elektronen in ihrem Elektronenspin selektiert analysiert werden und so Aussagen über die Wirkung des Untersuchungsobjekts messend und analysierend erfasst werden.

## Claims

1. Electron spectrometer for the supply and measurement of single electron electronic components and circuits including
connecting elements comprising hopping-conductive track conductors made of nanocrystalline material, which has separate energy levels similar to a 0-dimensional electron gas, which are connected to the single electron electronic component or circuit to be tested,
and lines made of metal, which are connected to the mentioned connecting elements and a voltage source.

2. Electron spectrometer for the supply and measurement of single electron electronic components and circuits according to Claim 1, wherein the energy splitting of the energy levels of the track conductors is at least 25 meV, which corresponds to the phonon energy at room temperature, in order to inhibit effects of thermal disturbance on the Coulomb blockade in the single electron electronic components and circuits at room temperature.

3. Electron spectrometer for the supply and measurement of single electron electronic components and circuits at room temperature according to Claims 1 and 2, wherein several quantum points are arranged downstream and upstream of the single electron electronic components and circuits to be tested, and the quantum points have energy level distances greater than 25 meV at room temperature.

4. Method for the supply and measurement of single electron electronic components and circuits using an electron spectrometer, wherein the electron spectrometer has connecting elements comprising hopping-conductive track conductors made of nanocrystalline material, which has separate energy levels similar to a 0-dimensional electron gas, which are connected to the single electron electronic component or circuit to be tested, and lines made of metal, which are connected to the mentioned connecting elements and a voltage source, wherein the electrons provided from the metal lines are selected in their energy by means of the discrete energy levels present in the hopping-conductive track conductors made of nanocrystalline material and are filtered in a spectroscopic manner according to energies and are supplied to the single electron electronics to be tested.

5. Method according to Claim 4, wherein several quantum points are arranged downstream and upstream of the single electron electronic components and circuits to be tested, wherein the quantum points have energy level distances greater than 25 meV at room temperature, that the quantum points can be influenced externally and selectively adjusted through the use of physical influences such as pressure, tensile force, local temperature, spectral illumination, electrical field strength, magnetic field strength in their energy splitting to match the electron energy with the single electron objects to be tested and that, as a result, the transmitted spectroscopically selected electrons are selectively defined and adjusted in their electron spin and are supplied to the test object.

6. Method according to Claim 5, wherein the transmitted spectroscopically selected electrons are selectively analysed in their electron spin and thus information on the effect of the test object is recorded by measurement and analysis.

## Revendications

1. Spectromètre d'électrons pour l'alimentation et la caractérisation de composants et de circuits électroniques à une charge, comprenant des éléments de liaison, composé
de pistes conductrices en matériau nanocristallin présentant des niveaux énergétiques similaires à ceux d'un gaz d'électrons zéro-dimensionnel, reliées à un composant ou à un circuit électronique à une charge,

et de conducteurs métalliques reliés auxdits éléments de liaison et à une source de tension.

2. Spectromètre d'électrons pour l'alimentation et la caractérisation de composants et de circuits électroniques à une charge, selon la revendication 1, où la ségrégation quantique des niveaux d'énergie des pistes conductrices est au moins de 25 meV, correspondant à l'énergie phononique, à température ambiante, afin d'inhiber, à température ambiante, les effets d'une perturbation thermique du blocage de Coulomb dans les composants et circuits électroniques à une charge.

3. Spectromètre d'électrons pour l'alimentation et la caractérisation de composants et circuits électroniques à une charge, à température ambiante, selon les revendications 1 et 2, où plusieurs points quantiques sont installés en amont et en aval des composants et circuits électroniques à une charge, objet de l'étude, et où les niveaux d'énergie des points quantiques, à température ambiante, sont espacés de plus de 25 meV.

4. Procédé pour l'alimentation et la caractérisation de composants et circuits électroniques à une charge mettant en oeuvre un spectromètre d'électrons, où le spectromètre d'électrons présente des éléments de liaison composés de pistes conductrices capables d'une conductivité par hopping en un matériau nanocristallin présentant des niveaux d'énergie similaires à ceux d'un gaz d'électrons zéro-dimensionnel, reliées au composant ou circuit électronique à une charge, et de conducteurs en métal reliés auxdits éléments de liaison et à une source de tension, où les électrons fournis par les conducteurs en métal sont sélectionnés en fonction de leur énergie par les niveaux d'énergie discrets des pistes conductrices en matériau nanocristallin capables de conductivité par hopping, pour être filtrés par voie spectroscopique, selon leur énergie, et envoyés à l'électronique à une charge, objet de l'étude.

5. Procédé suivant la revendication 4, où plusieurs points quantiques sont installés en amont et en aval des composants et circuits électroniques à une charge, dans lequel les niveaux d'énergies des points quantiques, à température ambiante, sont espacés de plus de 25 meV, où l'on peut intervenir sur la ségrégation d'énergie des points quantiques en se servant de phénomènes physiques, tels que la pression, la tension, la température locale, un éclairage à spectre défini, un champ électrique ou magnétique, afin de régler l'énergie des électrons aux besoin des objets à une charge à étudier, et que, par conséquent, les électrons passants, sélectionnés par voie spectroscopique, possèdent un spin défini et réglé, et sont envoyés à l'objet à étudier.

6. Procédé suivant la revendication 5, où le spin des électrons passants, sélectionnés par voie spectroscopique, est analysé afin d'obtenir, au moyen de mesures et d'analyses, des données sur l'efficacité de l'objet à étudier.

Fig.1

Fig.2

Fig.3

Fig.4